# FASCICULE DE BREVET EUROPEEN

(11) **EP 2 197 805 B1**
(45) Date de publication et mention de la délivrance du brevet: **05.12.2012**
(21) Numéro de dépôt: 08858866.0
(22) Date de dépôt: 03.10.2008
(51) Int. Cl.: C03C 17/22, C03C 21/00, H01L 21/20, H01L 21/336, H01L 21/762, H01L 29/16

(54) **PROCEDE DE FIXATION DE LAMELLES D'UN MATERIAU LAMELLAIRE SUR UN SUBSTRAT APPROPRIE**
VERFAHREN ZUR ANBRINGUNG VON LAMELLEN AUS EINEM LAMELLENMATERIAL AN EINEM GEEIGNETEN SUBSTRAT
METHOD OF FASTENING LAMELLAE OF A LAMELLAR MATERIAL TO A SUITABLE SUBSTRATE

(30) Priorité: 11.10.2007 FR 0707145
(43) Date de publication de la demande: 23.06.2010
(73) Titulaire: UNIVERSITÉ PIERRE ET MARIE CURIE (PARIS VI), 75005 Paris (FR); Centre National de la Recherche Scientifique, 75016 Paris (FR)
(72) Inventeur: SHUKLA, Abhay, F-94240 L'hay Les Roses (FR); MAZHER, Javed, F-75014 Paris (FR)
(74) Mandataire: Parzy, Benjamin Alain
(86) Numéro de dépôt international: PCT/FR2008/001385
(87) Numéro de publication internationale: WO 2009/074755

(56) Documents cités:
- FR-A- 2 592 874
- JP-A- 9 086 943
- US-A1- 2005 082 581

## Description

L'invention concerne un procédé de fixation de lamelles d'un matériau lamellaire sur un substrat approprié.

### ARRIERE-PLAN DE L'INVENTION

On connaît des matériaux susceptibles de présenter une structure cristalline particulière dans laquelle les atomes s'arrangent préférentiellement en structures planes atomiquement minces, ou lamelles, à l'intérieur desquelles les atomes sont fortement liés, des liaisons plus faibles s'exerçant entre les atomes de deux lamelles adjacentes. Ces lamelles peuvent être épaisses d'une ou de quelques couches monoatomiques.

Divers matériaux, par exemple, des matériaux semi-conducteurs tels que InSe ou GaS, des matériaux métalliques, éventuellement supraconducteurs, comme le graphite, NbSe₂, TaS₂ ou MgB₂, sont susceptibles de présenter une structure lamellaire. En ce qui concerne plus particulièrement le graphène, on connaît des méthodes de séparation mécanique des lamelles consistant soit à cliver ou racler un morceau de graphite, soit à appliquer sur le morceau de graphite un morceau de ruban adhésif et de l'arracher. Il faut alors rechercher avec un microscope optique d'éventuelles lamelles de graphène qui se seraient détachées du morceau de graphite. Pour manipuler ou traiter ces lamelles de graphène, et notamment éviter qu'elles ne s'enroulent, il convient alors de fixer les lamelles sur un substrat, par exemple à l'aide de résine, ce qui se révèle délicat. Ces procédés sont peu reproductifs et ne sont pas adaptés à une production de masse.

L'état de la technique est notamment illustré par les documents US 2005/082581, JP 09 086943 et FR 2592874.

### OBJET DE L'INVENTION

L'invention a pour objet une méthode de fixation de lamelles sur un substrat approprié particulièrement adap-adapté pour des matériaux lamellaires conducteurs ou semi-conducteurs.

### BREVE DESCRIPTION DE L'INVENTION

En vue de la réalisation de ce but, on propose un procédé de fixation de lamelles d'un matériau lamellaire au moins partiellement conducteur sur un substrat isolant contenant des oxydes susceptibles de se dissocier en ions d'une charge donnée mobiles et en ions de charge opposée fixes, comportant les étapes de :
- placer un échantillon du matériau lamellaire contre une surface du substrat ;
- provoquer dans le substrat la dissociation des oxydes ;
- soumettre le substrat et l'échantillon à un champ électrique au moyen d'une électrode en contact avec le substrat et d'une électrode en contact avec l'échantillon.

La dissociation des oxydes dans le substrat rend le substrat faiblement conducteur, suffisamment pour que, sous l'application du champ électrique, un courant électrique s'établisse entre les électrodes. Sous l'effet du champ électrique, les ions mobiles migrent vers l'électrode en contact avec le substrat, laissant sur place les ions de charge opposée immobiles, qui créent une charge électrique à l'interface entre le substrat et l'échantillon. Au bout d'un certain temps d'application du champ électrique, les lamelles de l'échantillon en contact avec le substrat se lient fortement au substrat.

Il suffit alors d'éliminer la majeure partie de l'échantillon pour ne laisser qu'une couche mince liée au substrat. Cette couche mince contient des lamelles en contact avec le substrat et qui sont fortement liées à ce dernier, et d'autres lamelles qui recouvrent au moins partiellement les lamelles liées au substrat et qui, étant moins fortement collées au substrat, peuvent être éliminées, par exemple par pelage. On a ainsi formé sur la surface du substrat une couche mince d'une épaisseur de quelques atomes, voire d'un seul atome.

Cette fixation est obtenue en quelques minutes, sans utilisation d'adhésif. Elle est très économique, et facilement industrialisable. Ce procédé vient en concurrence avec les procédés de fixation connus, par exemple par collage à l'aide de résine, mais également avec les procédés de dépôt de couches monocristallines ou des méthodes de croissance cristalline sur la surface du substrat, comme par exemple les méthodes d'évaporation, de jet moléculaire, de pulvérisation laser...

La taille de la couche mince ainsi fixée au substrat dépend beaucoup du matériau utilisé. On aura intérêt à partir d'un matériau de bonne qualité cristalline, par exemple un matériau monocristallin.

Les lamelles ainsi fixées au substrat peuvent faire l'objet de traitements par lithographie en vue de les intégrer dans des dispositifs électroniques.

### BREVE DESCRIPTION DES DESSINS

L'invention sera mieux comprise à la lumière de la description qui suit en référence aux figures des dessins annexés parmi lesquelles :
- la figure 1 est une vue schématique d'un dispositif permettant la mise en oeuvre du procédé de l'invention ;
- la figure 2 est une vue schématique d'un substrat en verre sur lequel des lamelles de graphène sont fixées, très agrandie.

### DESCRIPTION DETAILLEE DE L'INVENTION

Le procédé de l'invention est expliqué dans le cadre de l'obtention de lamelles de graphène.

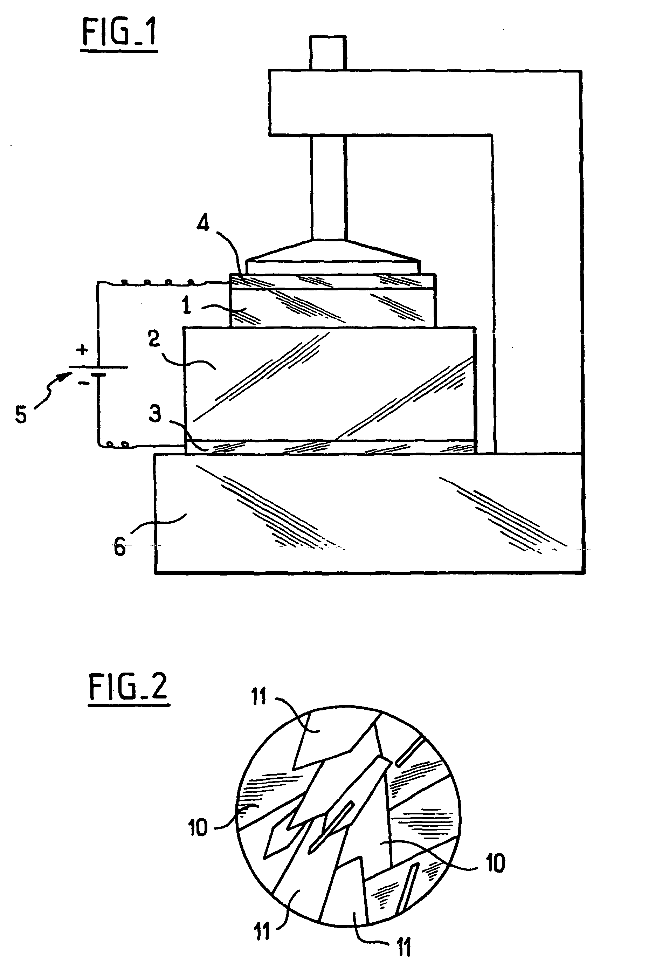

Comme cela est illustré à la figure 1, on place un échantillon de graphite 1, sur un substrat en verre 2, ici un verre borosilicaté connu sous l'appellation commerciale « PYREX 7740 ». Ici, on a utilisé un substrat 2 d'une surface d'environ 4 centimètres carrés, tandis que l'échantillon 1 a une surface d'environ 1 centimètre carré.

Pour assurer un bon contact entre l'échantillon 1 et le substrat 2, l'échantillon 1 est clivé pour exposer au substrat 2 une surface propre et vierge d'impuretés, tandis que la surface du substrat 2 est nettoyée avec des solvants (trichloréthylène, acétone et méthanol).

Une cathode 3 est disposée contre le substrat en verre 2, tandis qu'une anode 4 est disposée contre l'échantillon de graphite 1. La cathode 3 et l'anode 4 sont reliées à un générateur électrique 5. L'ensemble est placé sous une presse 6 pour presser l'échantillon de graphite 2 contre le substrat en verre 2. Une pression est appliquée, de l'ordre de 10⁶ Pascals, pour assurer un contact homogène entre le substrat de verre 2 et l'échantillon 1.

On porte le substrat 2 à une température d'environ 200 degrés Celsius, par exemple en mettant l'ensemble sous enceinte et en chauffant l'enceinte. On applique à l'ensemble un champ électrique d'environ 1,7 kilovolts.

A cette température, les oxydes alcalins Na₂O du substrat en verre 2 se dissocient en cations sodium Na⁺ et anions oxygène O²⁻. Sous l'effet du champ électrique, les cations sodium, mobiles, migrent vers la cathode 3, laissant sur place les anions oxygène fixes, qui créent une charge négative à l'interface entre le substrat en verre 2 et l'échantillon de graphite 1.

A l'application du champ électrique, un courant s'établit très vite, et celui-ci atteint sa valeur courante en quelques secondes, cette valeur étant typiquement de l'ordre de quelques dizaines à quelques centaines de microampères (cette valeur dépend notamment de la surface de contact entre l'échantillon et le substrat). Le collage de l'échantillon de graphite 1 sur le substrat en verre 2 commence dès le passage du courant, et est considéré comme achevé lorsque le courant redevient faible (quelques pourcents de la valeur courante), ici dans un temps de l'ordre de quelques minutes à environ 30 minutes.

Les valeurs de la température et du champ électrique sont données à titre indicatif. Ils dépendent du matériau utilisé, de la vitesse désirée de fixation. De façon générale, les inventeurs ont constaté qu'il est possible de compenser une diminution de l'un des paramètres par une augmentation de l'autre des paramètres, pour une même vitesse de fixation. Les fixations les plus rapides sont obtenues pour des températures et des champs électriques élevés. De préférence, on retiendra une température dans la plage [150°C;350°C], et un champ électrique dans la plage [1,2kV;2kV].

Il suffit alors de cliver l'échantillon pour laisser subsister sur le substrat en verre 2 qu'une couche mince illustrée schématiquement à la figure 2 composée de lamelles de graphène. Cette couche mince est d'une épaisseur de quelques atomes au plus.

Par observation microscopique ou par spectrographie Raman, il est possible de repérer dans la couche mince les lamelles 10 directement fixées au substrat et d'autres lamelles 11 qui recouvrent ces dernières et qui donnent localement à la couche mince une épaisseur de quelques atomes. Les lamelles 11 non directement fixées au substrat peuvent être facilement récupérées ou éliminées, par exemple par pelage à l'aide d'un ruban adhésif. On ne laisse alors sur le substrat en verre 2 que quelques lamelles de graphène fortement fixées au substrat, dont les épaisseurs varient d'une seule couche atomique à quelques couches atomiques.

Les lamelles de graphène ainsi collées au substrat n'ont bien sûr pas tendance à s'enrouler et sont donc facilement manipulables. Elles peuvent faire l'objet de divers traitements directement sur le substrat, dont des traitements lithographiques.

Des expérimentations menées avec du graphite HOPG (highly oriented pyrolitic graphite) et avec du graphite naturel ont permis d'obtenir des portions de graphène fixées au substrat d'une taille appréciable, jusqu'à 400 micromètres x 200 micromètres, et, couramment, de l'ordre de 5000 micromètres carrés. En utilisant de préférence des échantillons de graphite naturel quasi monocristallin, il semble possible d'obtenir des portions de graphène fixées au substrat de taille encore plus importante.

Il convient de ne pas confondre le procédé de l'invention avec celui par lequel on réalise un collage anodique de matériaux conducteurs sur du verre borosilicaté. Il est en effet connu de réaliser un collage anodique de silicium sur du verre par chauffage et soumission à un champ électrique de façon similaire à ce qui vient d'être décrit. Cependant, le collage anodique concerne des matériaux comme le silicium à structure cristalline à trois dimensions, présentant de fortes liaisons internes, et susceptibles de former facilement des liaisons oxydes Si-O-Si à l'interface avec le verre. Toutes ces liaisons sont très fortes et il est impossible de séparer le matériau collé au verre. On colle ainsi des épaisseurs macroscopiques, de l'ordre du millimètre ou plus, ce qui n'a rien à voir avec le procédé de l'invention.

Au contraire, le procédé de l'invention est appliqué à un matériau lamellaire et a pour objet de coller uniquement les lamelles directement en contact avec le substrat, soit une épaisseur de quelques atomes au plus. Il reste en outre possible de séparer les lamelles qui ne sont pas en contact direct avec le substrat.

Il convient également de noter que le procédé de l'invention n'est pas un simple dépôt électrostatique, mais bien un procédé de fixation. Les lamelles en contact avec le substrat sont fermement liées au substrat.

Cette méthode ouvre de nouvelles possibilités, et semble pouvoir être utilisée pour diverses applications, comme par exemple la réalisation de transistors FET ou MOSFET à base de graphène.

L'invention n'est pas limitée à ce qui vient d'être décrit, mais bien au contraire englobe toute variante entrant dans le cadre défini par les revendications.

En particulier, bien que l'on ait décrit le procédé de l'invention dans une application visant à obtenir des lamelles de graphène, on pourra bien sûr appliquer l'invention à d'autres types de matériaux lamellaires conducteurs ou semi-conducteurs. Ainsi, les inventeurs ont pu fixer selon le procédé de l'invention des lamelles du matériau semi-conducteur InSe et des lamelles du matériau métallique et supraconducteur NbSe₂.

De même, le substrat peut être en verre, comme décrit, mais peut également être en tout matériau isolant pouvant présenter dans certaines conditions une certaine conductivité par décomposition d'oxydes susceptibles de se séparer en ions d'une charge donnée mobiles et en ions d'une charge opposée fixes. Cette décomposition pourra être obtenue par chauffage, comme dans l'exemple illustré, ou par tout autre moyen propre à provoquer cette décomposition. En particulier, on pourra utiliser un substrat comprenant une couche mince de verre borosilicaté déposée sur un massif en silicium dopé, par exemple par pulvérisation magnétron à radiofréquence. Ce type de substrat permet de réduire le champ électrique nécessaire à la fixation des lamelles sur le substrat.

## Revendications

1. Procédé de fixation de lamelles d'un matériau lamellaire au moins partiellement conducteur sur un substrat (2) isolant contenant des oxydes susceptibles de se dissocier en ions d'une charge donnée mobiles et en ions de charge opposée fixes, comportant les étapes de :
- placer un échantillon (1) du matériau lamellaire contre une surface du substrat ;
- provoquer la dissociation des oxydes du substrat ;
- soumettre le substrat et l'échantillon à un champ électrique au moyen d'une électrode en contact avec le substrat et d'une électrode en contact avec l'échantillon.

2. Procédé selon la revendication 1, dans lequel on choisit un substrat en verre borosilicaté contenant des oxydes alcalins Na₂O susceptibles de se dissocier en cations Na⁺ mobiles et anions fixes O²⁻ sous l'effet de la température, et dans lequel on chauffe le substrat pour provoquer cette dissociation.

3. Procédé selon la revendication 2, dans lequel on chauffe le substrat à une température comprise dans l'intervalle [150°C;350°C].

4. Procédé selon la revendication 1, dans lequel le champ électrique est compris dans l'intervalle [1, 2kV; 2kV].

5. Procédé selon la revendication 1, dans lequel le matériau lamellaire est du graphite.

## Claims

1. A method of fastening lamellae of a lamellar material that is at least partially conductive onto an insulating substrate (2) containing oxides that are suitable for dissociating into mobile ions of given charge and stationary ions of opposite charge, the method comprising the steps of:
• placing a sample (1) of the lamellar material against a surface of the substrate;
• causing the oxides of the substrate to dissociate; and
• subjecting the substrate and the sample to an electric field by means of an electrode in contact with the substrate and an electrode in contact with the sample.

2. A method according to claim 1, wherein a substrate is connected made of borosilicate glass containing alkali oxides Na₂O suitable for dissociating into mobile Na⁺ cations and stationary O²⁻ anions under the effect of temperature, and wherein the substrate is heated to cause said dissociation.

3. A method according to claim 2, wherein the substrate is heated to a temperature lying in the range [150°C, 350°C].

4. A method according to claim 1, wherein the electric field lies in the range [1.2 kV, 2 kV].

5. A method according to claim 1, wherein the lamellar material is graphite.

## Patentansprüche

1. Verfahren zum Fixieren von Lamellen aus einem zumindest teilweise leitenden lamellaren Material auf einem isolierenden Substrat, das Oxide enthält, die geeignet sind, sich in Ionen einer gegebenen mobilen Ladung und in Ionen einer festen entgegengesetzten Ladung zu dissoziieren, umfassend die folgenden Schritte:
- Eine Probe (1) aus lamellarem Material auf eine Substratoberfläche aufbringen;
- Auslösen der Dissoziation der Oxide des Substrats;
- Das Substrat und die Probe mittels einer Elektrode, die mit dem Substrat Kontakt hat, und einer Elektrode, die mit der Probe Kontakt hat, einem elektrischen Feld aussetzen.

2. Verfahren nach Anspruch 1, bei dem ein Substrat aus Borsilikatglas gewählt wird, das alkaline Na₂O Oxide enthält, die geeignet sind, sich unter dem Einfluss der Temperatur in bewegliche Na⁺ Kationen und in feste O²⁻ Anionen zu dissoziieren, und bei dem das Substrat erhitzt wird, um diese Dissoziation auszulösen.

3. Verfahren nach Anspruch 2, bei dem das Substrat auf eine im Intervall [150°C; 350°C] enthaltene Temperatur erhitzt wird.

4. Verfahren nach Anspruch 1, bei dem das elektrische Feld im Intervall [1,2kV; 2kV] enthalten ist.

5. Verfahren nach Anspruch 1, bei dem das lamellare Material aus Graphit besteht.
